# EUROPÄISCHE PATENTANMELDUNG

(11) **EP 1 930 948 A1**
(43) Veröffentlichungstag der Anmeldung: **11.06.2008**
(21) Anmeldenummer: 07021748.4
(22) Anmeldetag: 09.11.2007
(51) Int. Cl.: H01L 27/142, H01L 31/02, H01L 31/0224, H01L 31/05

(54) **Elektrodenanordnung für ein Photovoltaisches Modul in Reihenschaltung**

(30) Priorität: 06.12.2006 DE 102006057454
(71) Anmelder: SCHOTT Solar GmbH, 63755 Alzenau (DE)
(72) Erfinder: Lechner, Peter, 85591 Vaterstetten (DE); Psyk, Walter, 81371 München (DE); Heckel, Erwin, 84072 Au in der Hallertau (DE)
(74) Vertreter: Haft, von Puttkamer, Berngruber

(57) **Zusammenfassung**

Ein photovoltaisches Modul (10) besteht aus mehreren miteinander verschalteten Submodulen (11, 12, 13). Jedes Submodul (11, 12, 13) weist eine transparente Frontelektrodenschicht (15), eine Halbleiterschicht (16) und eine Rückelektrodenschicht (17) auf, die zur Bildung serienverschalteter streifenförmiger photovoltaischer Zellen (C) jeweils Trennlinien (18, 19, 20) aufweisen. Die äußeren Zellen (Cn, Cl) zweier benachbarter Submodule (11 und 12 bzw. 12 und 13) sind zu einer einzigen Abgriffzelle (Cn, Cl) zur Stromabnahme vereinigt, wobei die Trennlinien (18,19, 20) der beiden benachbarten Submodule (11 und 12 bzw. 12 und 13) zu ihrer gemeinsamen Abgriffzelle spiegelsymmetrisch angeordnet sind.

## Beschreibung

Die Erfindung bezieht sich auf ein photovoltaisches Modul nach dem Oberbegriff des Anspruchs 1. Sie hat auch ein Verfahren zur Herstellung des Moduls zum Gegenstand

Bei der Herstellung von photovoltaischen Dünnschichtmodulen wird in der Regel ein elektrisch isolierendes Substrat, wie eine Glasplatte, großflächig mit einer transparenten Frontelektrodenschicht, einer Halbleiterschicht und einer Rückelektrodenschicht beschichtet. Bei der Abscheidung jeder Schicht wird ein Strukturierungsschritt durchgeführt. D. h., die Schichten werden sukzessive z. B. mit Laser, mechanisch oder chemisch in Streifen getrennt, wobei die Trennlinien so verlaufen, dass die gebildeten streifenförmigen photovoltaischen Zellen durch Überlappen von Bereichen der Frontelektrodenschicht und der Rückelektrodenschicht serienverschaltet sind.

Die optimale Breite der streifenförmigen Zellen wird durch den Flächenwiderstand der Frontelektrodenschicht und der Rückelektrodenschicht sowie die Impedanz der Zelle bei Beleuchtung bestimmt. Typischerweise ergeben sich bei einem auf Leistung optimierten Modul je nach Dünnschichttechnologie Zellenbreiten von etwa 4 - 10 Millimeter bei Dünnschicht-Einfachzellen, also Zellen mit nur einem p-n-Übergang, z. B. mit einer Halbleiterschicht aus Silizium, insbesondere amorphem (a-Si) oder mikrokristallinem (µ-Si) Silizium oder aus Kupfer-Indium- oder Kupfer-Indium-Gallium-Sulfid und/oder -Selenid oder aus Cadmiumtellurid, während die Zellenbreite bei Siliziumdünnschicht-Stapelzellen, also Zellen mit mehreren p-n-Übergängen, z. B. a-Si/a-Si und a-Si/µc-Si-Tandem- oder auch Tripelzellen meist eine Breite von 7 bis 20 Millimeter besitzen. Aus der technologieabhängigen Leerlauf- und Arbeitspunktspannung und aus der optimalen Zellenbreite ergibt sich für Dünnschichttechnologien eine spezifische Leerlaufspannung von etwa 100 Volt pro Meter Substratabmessung, also für ein aus serienverschalteten streifenförmigen Zellen bestehendes Modul mit einer Breite von einem Meter. Bei einem Modul mit typischer Kennlinie beträgt die Arbeitspunktspannung etwa 75 - 85 % der Leerlaufspannung. Mit zunehmender Substratabmessung nimmt damit gleichzeitig die Modulspannung zu.

Für bestimmte Anwendungen ist jedoch eine niedrige Spannung wünschenswert, beispielsweise bei Einsatz photovoltaischer Module in 12 Volt-Batteriesystemen. Aber auch bei netzgekoppelten Anlagen wird oft eine niedrige Modulspannung bevorzugt. Dabei können erheblich mehr Module in einem Strang in Serie bis zur zulässigen Systemspannung verschaltet werden. Typische Dünnschichtmodule weisen eine spezifische Leistung von 1 - 2 Watt pro Volt Leerlaufspannung auf. Bei einer für das Modul zulässigen Systemspannung von z. B. 600 Volt ergibt sich damit eine maximal mögliche Leistung pro Strang von 600 - 1200 Watt. Module mit einer kristallinen Halbleiterschicht erzielen dagegen 5 bis 10 Watt pro Volt Modulspannung, wodurch sich eine wesentlich höhere Leistung pro Strang ergibt bzw. weniger Stränge für eine vorgegebene Leistung eines photovoltaischen Moduls ergeben, was zu wesentlichen Kosteneinsparungen führt.

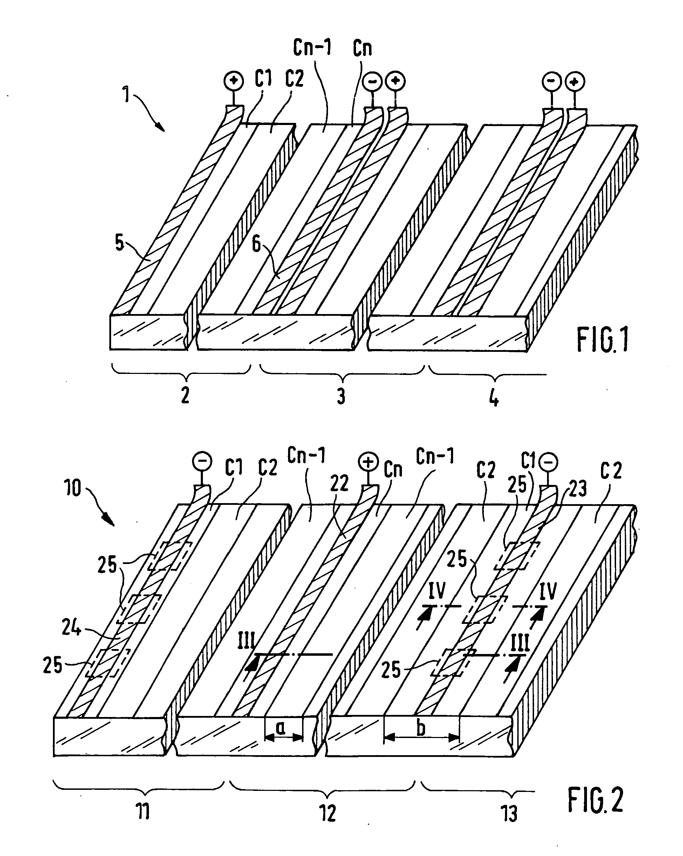

Um die Spannung eines photovoltaischen Moduls zu senken, ist es, wie in Figur 1 dargestellt, bekannt, das Modul 1 in mehrere gleich große Submodule 2, 3, 4 mit entsprechend geringer Spannung zu unterteilen, die über eine externe Verschaltung parallel verschaltet werden.

Wie anhand des Submoduls 2 in Figur 1 veranschaulicht, besteht jedes Submodul aus mehreren Zellen, d. h. der dargestellten 1. und 2. Zelle C1, C2, der vorletzten und letzten Zelle Cn-1 bzw. Cn und den nicht dargestellten dazwischen liegenden Zellen. Die beiden äußeren Zellen, also die erste und die letzte Zelle C1 bzw. Cn sind jeweils als Abgriffzellen oder Pole zur Stromabnahme ausgebildet und dazu mit Kontaktbändchen 5,6 versehen. Die dazwischen liegenden Zellen weisen jeweils die gleiche Fläche auf, d.h., da sie gleich lang sind, die gleiche Breite. Von den Abgriffzellen, also den beiden äußeren Zellen jedes Submoduls ist mindestens eine photovoltaisch inaktiv, d. h. sie trägt nicht zur Leistungserzeugung bei. Damit kann mit dem Modul 1 nach Figur 1 zwar eine niedrige Modulspannung erzielt werden, jedoch führen die zahlreichen Abgriffzellen zu einer Minderung der photoaktiv genutzten Fläche und damit der Modulleistung.

Aufgabe der Erfindung ist es, ein Modul mit niedriger Spannung, aber hoher Leistung bereitzustellen.

Dies wird erfindungsgemäß mit dem im Anspruch 1 gekennzeichneten photovoltaischen Modul erreicht. In den Ansprüchen 2 - 4 sind bevorzugte Ausführungsformen der Erfindung wiedergegeben. Der Anspruch 5 hat ein bevorzugtes Verfahren zur Herstellung des Moduls zum Gegenstand, das durch die Ansprüche 6 und 7 vorteilhaft ausgestaltet wird.

Nach der Erfindung sind die äußeren Zellen zweier benachbarter Submodule zu einer gemeinsamen Abgriffzelle vereinigt. Zugleich sind die Trenn- oder Verschaltungslinien der beiden benachbarten Submodule spiegelsymmetrisch zu der gemeinsamen Abgriffzelle angeordnet.

Durch die Zusammenlegung der äußeren Abgriffzellen zweier benachbarter spiegelsymmetrischer Submodule zu einer einzigen Abgriffzelle werden erfindungsgemäß wesentlich weniger Abgriffzellen benötigt, die die Leistung des Moduls mindern. D. h. statt vier Abgriffzellen, wie sie bei einem Modul aus zwei Submodulen nach dem Stand der Technik erforderlich sind, werden erfindungsgemäß nur drei Abgriffzellen benötigt, und beispielsweise bei einem Modul aus vier Submodulen nur fünf Abgriffzellen gegenüber acht Abgriffzellen nach dem Stand der Technik.

Die Abgriffzellen können photovoltaisch inaktiv und damit nur als Pol wirksam sein oder photoaktiv und mit einem Stromsammler versehen sein.

Die Symmetrieebene zur spiegelsymmetrischen Anordnung der Trenn- oder Verschaltungslinien in den einzelnen Schichten, also der Frontelektrodenschicht, Halbleiterschicht und Rückelektrodenschicht, verläuft in der Mittelsenkrechten der Abgriffzellen zwischen den beiden einander benachbarten Submodulen.

Damit weisen erfindungsgemäß die beiden benachbarten Submodule eine gemeinsame erste Zelle auf, an die sich beiderseits die zweite, dritte usw. bis zur letzten Zelle des einen bzw. anderen Submoduls anschließen. Damit können erfindungsgemäß die photovoltaisch inaktiven Abgriffzellen von zwei benachbarten, gespiegelten Submodulen zusammengelegt werden. Erfindungsgemäß wird dadurch die Fläche einer photovoltaisch inaktiven Abgriffzelle eingespart, desgleichen ein Kontaktbändchen.

Ferner können die photoaktiven Abgriffzellen von zwei benachbarten, gespiegelten Submodulen nebeneinander angeordnet werden. Dadurch wird eine weitere Flächeneinsparung durch den Wegfall der Trennlinien zwischen den benachbarten Submodulen erzielt. Zusätzlich wird ein Kontaktbändchen eingespart.

Die Submodule des erfindungsgemäßen Moduls werden beispielsweise über eine externe Verschaltung parallel geschaltet. Um die Vorteile der Erfindung optimal zu verwirklichen, besteht das Modul vorzugsweise aus einer geraden Anzahl von Submodulen, vorzugsweise mindestens vier Submodulen. Die Fläche der Zellen zwischen den Abgriffzellen jedes Submoduls ist gleich groß. D.h. bei gleicher Länge der Zellen weisen die Zellen zwischen den Abgriffzellen die gleiche Breite auf. Die photoaktiven Abgriffzellen können die gleiche Fläche bzw. Breite wie die dazwischen liegenden Zellen besitzen, jedoch, wie nachstehend näher erläutert, als photoaktive Zellen auch großflächiger bzw. breiter ausgebildet sein. Falls die Abgriffzelle photovoltaisch inaktiv ausgebildet ist, kann sie jedoch auch schmäler als die anderen Zellen sein, wobei sie vorzugsweise etwa so breit ist wie das Kontaktbändchen.

Die transparente Frontelektrodenschicht, die dem einfallenden Licht zugewandt ist, kann z. B. eine TCO (transparent conductive oxide)-Schicht sein, beispielsweise Zink- oder Zinnoxid. Sie kann z. B. auf eine Glasplatte als Substrat aufgebracht sein. Die Halbleiterschicht des erfindungsgemäßen Moduls kann beispielsweise aus Silizium, beispielsweise a-Si oder µC-Si oder aus Kupferindium- oder Kupferindiumgalliumsulfid und/oder -selenid oder aus Cadmiumtellurid bestehen. Wenn eine Einfachzelle, also eine Halbleiterschicht mit nur einem p-n-Übergang zur Anwendung kommt, kann die Breite einer Zelle etwa 3 - 15 Millimeter, insbesondere 4 - 10 Millimeter betragen. Bei Siliziumdünnschicht-Stapelzellen, beispielsweise a-Si/a-Sioder a-Si/µc-Si-Tandem oder auch Tripelzellen, also bei einer Halbleiterschicht mit zwei, drei bzw. mehreren p-n-Übergängen beträgt die Breite der Zellen vorzugsweise 5 - 30, insbesondere 7 - 20 Millimeter. Dabei nimmt der Wirkungsgrad mit zunehmender Streifenbreite ab. Andererseits wirkt sich bei einer geringeren Streifenbreite der Flächenverlust durch die größere Anzahl von Verschaltungs- oder Trennlinien nachteilig aus.

Die Rückelektrodenschicht kann durch eine Metall- oder einer elektrisch leitende Metalloxidschicht gebildet sein, ggf, auch aus TCO.

Die Frontelektrodenschicht, die Halbleiterschicht und die Rückelektrodenschicht werden im Allgemeinen durch chemische und/oder physikalische Dampfabscheidung aufgetragen. Die Verschaltungs- oder Trennlinien in den einzelnen Schichten können mit einem Laser oder mechanisch oder auf chemischem Wege, beispielsweise durch Ätzen gebildet werden.

Das erfindungsgemäße Modul kann bei niedrigen Spannungen, beispielsweise bei Batteriesystemen, beispielsweise 12 Volt-Batteriesystemen zum Einsatz kommen. Es ist auch bei netzgekoppelten Anlagen anwendbar, wobei mehrere Module in einem Strang in Serie zu der zulässigen Systemschaltung verschaltet werden können.

Vorzugsweise wird für das erfindungsgemäße Modul die Superstrat-Technologie eingesetzt, d. h. die Abgriffzellen werden an der Rückelektrode, also auf der der Einstrahlseite abgewandten Seite der Halbleiterschicht kontaktiert.

Wenn die Abgriffzelle photoaktiv ausgeführt ist, wird vorzugsweise ein Kontaktierverfahren verwendet, mit dem die Photoaktivität insbesondere durch einen elektrischen Kurzschluss nicht zerstört, jedenfalls weitgehend aufrechterhalten wird. Die Rückelektrodenschicht der die Abgriffzelle bildenden Zelle kann dazu mit einer klebefähigen, elektrisch leitenden Paste versehen werden, auf die ein metallisches Kontaktbändchen aufgebracht wird. Die Paste kann z.B. mit Silber gefüllt sein. Auch kann ein thermisch aktivierbarer Kleber verwendet werden.

Zudem kann ein selbstklebendes Kontaktbändchen eingesetzt werden, beispielsweise mit einer Klebeschicht auf Acryl-Silicon- oder Kautschukbasis, die mit leitfähigen Partikeln, wie kleinen Metallkugeln oder metallisierten Keramik- oder Metallkugeln gefüllt sein kann. Auch kann ein Kontaktbändchen verwendet werden, das derart geprägt ist, dass seine erhabenen Stellen in direktem Kontakt mit der Rückelektrodenschicht stehen, während die vertieften Stellen elektrisch nicht leitend ausgebildet und mit einem Kleber gefüllt sind und damit für die Adhäsion des Kontaktbändchens an der Abgriffzelle sorgen. Eine thermische Aktivierung ist dann in der Regel nicht notwendig.

Auch Lötverfahren können zur zerstörungsfreien Kontaktierung der photoaktiven Zelle verwendet werden. Um Lötverfahren auf Basis von Zinn-Lot einsetzen zu können, muss die Zelle allerdings mit einer lötbaren Metallschicht versehen sein, beispielsweise mit einer Zinn-, Silber- oder Kupferschicht. Auch kann eine Nickelschicht verwendet werden, da sie eine Diffusionsbarriere für Zinn, Silber und Kupfer bildet und die Zelle vor einer Diffusion dieser Metalle aus dem Lot während des Lötvorgangs und beim späteren Betrieb des photovoltaischen Moduls besonders gut schützt. Die Nickelschicht kann dabei z.B. zehn Nanometer bis 1 Mikrometer betragen. Der Lötvorgang selbst kann entweder manuell oder automatisch mit einem Lötkolben durchgeführt werden.

Die Lötstelle kann zur berührungslosen thermischen Aktivierung kurzzeitig mit kurzwelligem Licht, beispielsweise einer Halogenlampe oder mit einem Laserstrahl bestrahlt werden. Ein weiteres berührungsloses Lötverfahren ist die Anwendung von kurzzeitig in das Kontaktbändchen induktiv eingekoppelter Hochfrequenzenergie. Dabei ist wichtig, dass im wesentlichen das metallische Kontaktbändchen von der absorbierten Hochfrequenzenergie aufgeheizt wird, nicht jedoch die sehr viel dünnere Rückelektrodenschicht.

Eine wesentliche voraussetzung für den Erhalt einer langzeitstabilen Lötverbindung ist die chemische Aktivierung der beiden zu verbindenden Oberflächen. Dazu ist ein vorverzinntes metallisches Kontaktbändchen geeignet. Auch kann die Oberfläche der photoaktiven Zelle lokal verzinnt werden. Statt der Verzinnung kann auch ein Flussmittel auf die Zelle an der späteren Lötstelle lokal aufgebracht werden. Ferner kann zur chemischen Aktivierung der zu lötenden Oberfläche ein mit Flussmittel behandeltes, vorverzinntes Kontaktbändchen verwendet werden.

Anstelle eines Kontaktbändchens kann die Abgriffzelle auch eine Verzinnung in Form einer Leiterbahn aufweisen, die einen einem Kontaktbändchen ähnlichen Querschnitt aufweist.

Wenn durch die Kontaktierung die Photoaktivität der Abgriffzellen beeinträchtigt wird, hat es sich als besonders vorteilhaft erwiesen, durch Trennlinien abgetrennte Bereiche der Abgriffzellen zur Kontaktierung zu verwenden, um dadurch die Photoaktivität der Abgriffzellen außerhalb dieser Bereiche zu erhalten.

Die photoaktive Fläche der Abgriffzelle muss dann jedoch gleich groß wie die Fläche der Zellen zwischen den Abgriffzellen sein. D.h. die Abgriffzelle weist insgesamt eine größere Fläche auf, also bei gleicher Länge eine größere Breite, um die für die Kontaktierung vorgesehenen, abgetrennten Bereiche zu kompensieren.

Die Kontaktierung in diesen Bereichen kann beispielsweise durch Löten, Schweißverfahren, wie Ultraschall-Schweißen und dgl. erfolgen. Zwar kann dann in diesen Bereichen die Photoaktivität der Abgriffzellen verloren gehen. Vorzugsweise werden diese isolierten Bereiche in ihrer Größe so gewählt, dass die Photoaktivität der Abgriffzellen im wesentlichen erhalten bleibt. Dazu können diese Bereiche beispielsweise in einem Abstand von 10 - 300 Millimeter angeordnet werden und eine Fläche von beispielsweise 5 - 50 Quadratmillimeter besitzen, um mit einem Kontaktbändchen kontaktiert zu werden, ohne die photoaktive Zelle außerhalb dieser Bereiche zu schädigen.

Die Trennlinien für die isolierten Bereiche können dabei während des Herstellungsprozesses im Rahmen der Strukturierung, also der Erzeugung der Trennlinien für die Verschaltung der Zellen, gebildet werden, also beispielsweise durch Laser, mechanisch oder auf chemischem Wege. Vorzugsweise wird dazu die transparente Frontelektrodenschicht mit diesen kleinen elektrisch getrennten Bereichen versehen.

Vorzugsweise werden nach der Erfindung die Kontaktbändchen mit der Rückelektrodenschicht in den abgetrennten Bereichen durch Löten verbunden. Die Kontaktbändchen sind vorzugsweise vorverzinnt und mit einem Flussmittel versehen. Das Löten kann durch Anwendung von in das Kontaktbändchen induktiv eingekoppelter Hochfrequenzenergie erfolgen.

Die Rückelektrodenschicht kann auch aus mehreren Einzelschichten bestehen, wobei die äußerste Einzelschicht durch eine Metallschicht gebildet wird, die eine Diffusionsbarriere beim Löten mit dem vorverzinnten und mit dem Flussmittel versehenen Kontaktbändchen darstellt.

Beispielsweise kann die Rückelektrodenschicht aus einer Zinnoxidschicht mit einer Stärke von z.B. 80nm einer Aluminiumschicht mit einer Stärke von beispielsweise 250nm und einer Nickelschicht als Diffusionsbarriere mit einer Stärke von 10nm bis 1µm, vorzugsweise 50 bis 100nm als äußerster Einzelschicht bestehen. Die zum Löten verwendete induktiv eingekoppelte Hochfrequenz kann beispielsweise 100 kHz bis 2 MHz betragen.

In der beigefügten Zeichnung zeigen:
Figur 1 ein photovoltaisches Modul nach dem Stand der Technik in perspektivischer, teilweiser Wiedergabe;
Figur 2 beispielhaft eine Ausführungsform des erfindungsgemäßen photovoltaischen Moduls in perspektivischer, teilweiser Wiedergabe;
Figur 3 und 4 einen Schnitt durch das Modul nach Figur 2 entlang der Linie III-III bzw. IV- IV;
Figur 5 und 6 eine Draufsicht auf eine photoaktive Abgriffzelle mit isoliertem Minus- bzw. Pluspol; und
Figur 7 und 8 die Verschaltung eines Moduls mit vier Submodulen nach dem Stand der Technik bzw. nach der Erfindung.

Gemäß Figur 2 besteht das photovoltaische Modul 10 aus mehreren Submodulen 11, 12, 13.

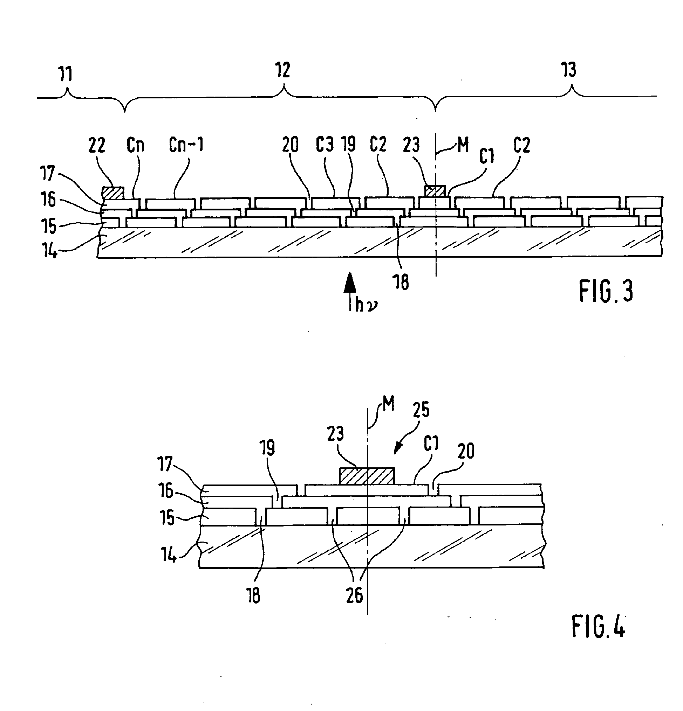

Dazu sind gemäß Figur 3 auf der Seite des Lichteinfalls (hv) des Moduls auf einem transparenten Substrat 14, beispielsweise einer Glasplatte, eine transparente Frontelektrodenschicht 15, eine Halbleiterschicht 16 und eine Rückelektrodenschicht 17 z. B. durch Dampfabscheidung aufgebracht. Die einzelnen Schichten werden z. B. mit einem Laser jeweils mit Trennlinien versehen, und zwar die Frontelektrodenschicht 15 mit den Trennlinien 18, die Halbleiterschicht 16 mit den Trennlinien 19 und die Rückelektrodenschicht 17 mit den Trennlinien 20. Dadurch überlappen sich die Frontelektrodenschicht 15 und die Rückelektrodenschicht 17, wodurch serienverschaltete streifenförmige photovoltaische Zellen C gebildet werden.

Die beiden äußeren Zellen der beiden benachbarten Submodule 11 und 12 bzw. 12 und 13 sind dabei zu einer Abgriffzelle vereinigt. D. h. die Abgriffzelle mit dem Plus-Pol bildet zugleich die letzte Zelle Cn des Submodules 11 wie die letzte Zelle Cn des benachbarten Submodules 12, während die Abgriffzelle mit dem Minuspol zugleich die erste Zelle C1 des Submodules 12 und die erste Zelle C1 des benachbarten Submodules 13 bildet.

Alle Zellen C weisen die gleiche Länge auf. Die Zellen C2 bis Cn-1 zwischen den Abgriffzellen C1, Cn weisen die gleiche Breite a auf. Die Abgriffzelle C1 mit dem Minuspol am Außenrand des Submoduls 11 und damit des Moduls 10 weist die gleiche Breite a auf, wie die Zellen C2 bis Cn-1.

Die gemeinsame photovoltaisch inaktive Abgriffzelle Cn mit dem Pluspol weist eine geringere Breite als a auf. Typischerweise ist die Breite des Kontaktbändchens die gleiche wie der Zellen C2 bis Cn-1 mit der Breite a.

Demgegenüber weist die gemeinsame photovoltaisch aktive Abgriffzelle mit dem Minuspol zwischen den Submodulen 12 und 13 die Breite b auf, die der doppelten Breite a der übrigen Zellen entspricht, plus gegebenenfalls einer zusätzlichen Breite zur Kompensation der photovoltaisch inaktiven Bereiche 25 zur Kontaktierung des Kontaktbändchens 23, wie nachstehend näher erläutert. Die in Rede stehende Zelle C1 stellt die photoaktive Abgriffzelle für die benachbarten Submodule 12 und 13 dar. Auf diese Weise wird eine weitere Flächeneinsparung durch den Wegfall von Trennlinien zwischen den beiden Submodulen 12, 13 erzielt. Auch ist nur das eine Kontaktbändchen 23 zur Kontaktierung erforderlich.

Damit sind gemäß Figur 3 die Trennlinien 18, 19 und 20 der beiden benachbarten Submodule 12 und 13 spiegelsymmetrisch zueinander angeordnet, wobei die Symmetrieebene durch die Mittelsenkrechte M verläuft. Die gleiche Spiegelsymmetrie weisen die beiden benachbarten Submodule 11 und 12 auf.

D. h. die beiden Submodule 12 und 13 haben eine gemeinsame erste Zelle C1, an die sich beiderseits die zweite Zelle C2, die dritte Zelle C3 usw. bis zur letzten Zelle Cn spiegelsymmetrisch anschließen, während die beiden Submodule 11 und 12 die letzte Zelle Cn gemeinsam haben, an die sich beiderseits die vorletzte Zelle Cn-1 usw. bis zur ersten Zelle C1 dieser beiden Submodule 11 und 12 anschließen.

Die Abgriffzellen Cn und C1 sind zur Stromabfuhr mit Kontaktbändchen 22, 23 versehen, desgleichen die erste Zelle C1 des Submoduls 11, welche das Modul 10 an dieser Seite abschließt, mit einem Kontaktbändchen 24.

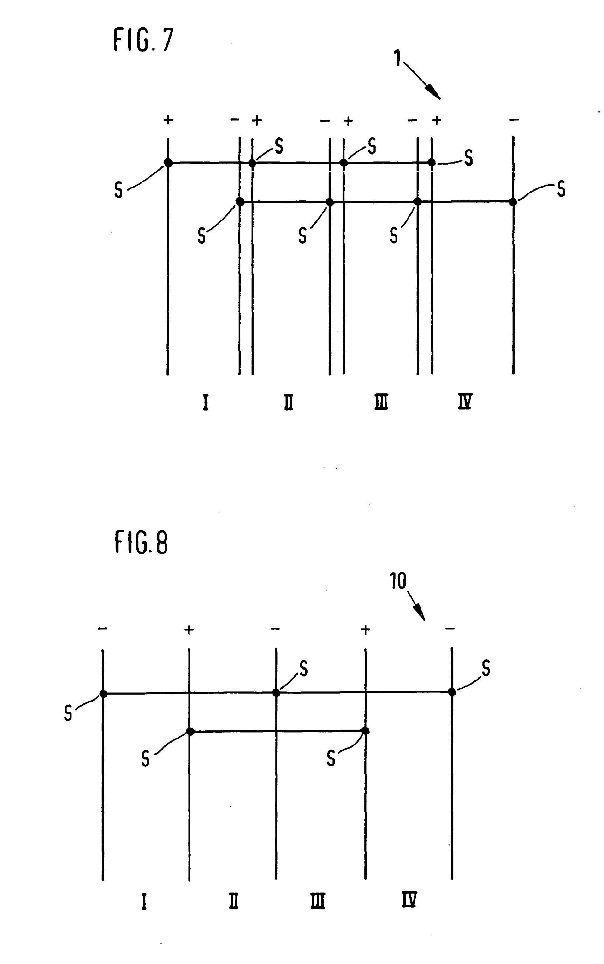

Die Minuspole und die Pluspole der Submodule 11, 12, 13 des Moduls 10 sind beispielsweise über eine externe Verschaltung parallel verschaltet. Dabei ist in Figur 7 die Verschaltung eines bekannten Moduls 1 mit vier Submodulen I, II, III und IV dargestellt und in Figur 8 die eines Moduls 10 mit vier Submodulen I, II, III und IV nach der Erfindung, wobei die Lötverbindungen mit "S" bezeichnet sind.

Wie Figur 7 und 8 zeigt, verringert sich entsprechend der reduzierten Anzahl der Abgriffzellen erfindungsgemäß auch die Anzahl der Lötverbindungen S, und zwar bei dem dargestellten Beispiel eines Moduls mit vier Submodulen I-IV von acht (Figur 7) auf fünf (Figur 8).

Die Trennlinien 18, 19 und 20 können auch anders angeordnet sein als in Figur 3 und 4 dargestellt. So kann beispielsweise die Trennlinie 20 sowohl die Rückelektrode 17 wie die Halbleiterschicht 16 auftrennen.

Wie in Figur 2 anhand der Abgriffzelle C1 mit dem Minuspol angedeutet, kann diese gestrichelt dargestellte Bereiche 25 aufweisen, welche, wie aus Figur 4 ersichtlich, durch Trennlinien 26 in der Frontelektrodenschicht 15 gebildet werden. Das Kontaktbändchen 23, 24 wird an den Bereichen 25 mit der Abgriffzelle C1 verbunden, beispielsweise angelötet. Obwohl die Abgriffzelle C1 in den Bereichen 25 durch das Anlöten photoinaktiv wird, bleibt damit ihre Photoaktivität außerhalb der Bereiche 25 unbeeinträchtigt.

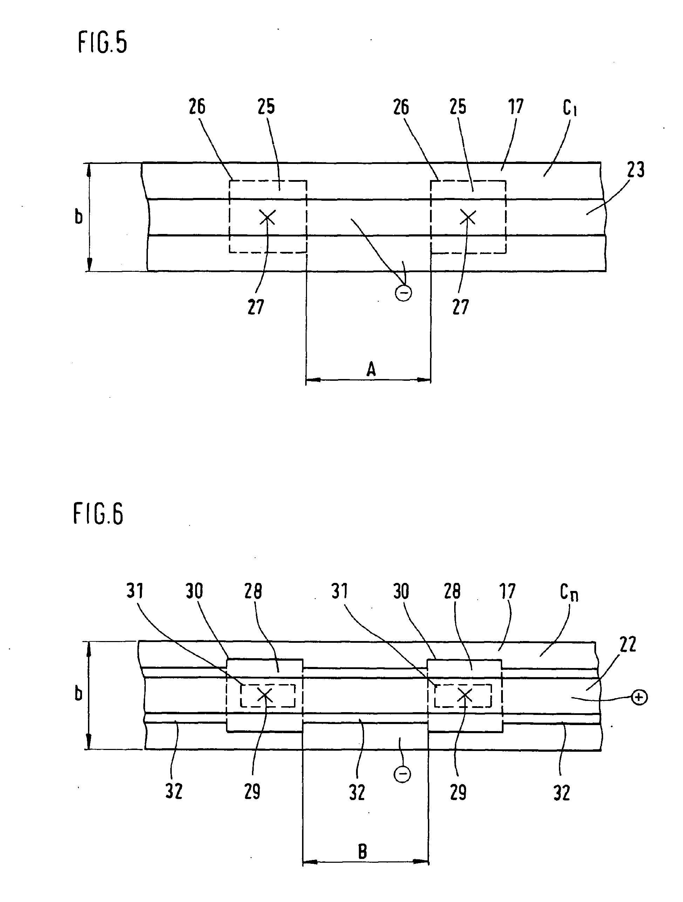

In Figur 5 ist in vergrößerter Wiedergabe in der Draufsicht die Abgriffzelle C1 mit dem Minuspol nach Figur 2 bis 4 dargestellt. Figur 5 ist zu entnehmen, dass in der Mitte des Bereichs 25 das Kontaktbändchen 23 bei 27 mit der Rückelektrodenschicht 17 z.B. durch Löten und damit unter Zerstörung, jedenfalls Beeinträchtigung der Photoaktivität im Bereich 25 verbunden ist. Die für die Photoaktivität verlorener Bereiche 25 werden durch eine entsprechende Vergrößerung der Breite b der Abgriffzelle C1 kompensiert.

In Figur 6 ist eine Ausführungsform einer photoaktiven Abgriffzelle Cn mit dem Pluspol in vergrößerter Wiedergabe in der Draufsicht dargestellt. Hier ist in der Mitte der Bereiche 28 das Kontaktbändchen 22 bei 29 mit der Rückelektrode 17 z.B. durch Löten in den Bereichen 28 verbunden. Die Trennlinien 30, die die Bereiche 28 bilden, sind dabei in der Rückelektrode 17 oder alternativ in der Rückelektrode 17 und der Halbleiterschacht 16 vorgesehen, um die Bereiche 28 gegenüber der umgebenden, negativ gepolten Abgriffzelle zu isolieren. Zudem sind innerhalb jedes Bereichs 28 Trennlinien 31 in der Halbleiterschicht 16, vorgesehen, um das Potential der Frontelektrode 15 auf den Rückelektrodenbereich 28 zu schalten. Es wird also das positive Potential der Frontelektrode 15 dem abgetrennten Rückelektrodenbereich 28 zugeführt. Um zu verhindern, dass das positiv gepolte Kontaktbändchen 22 mit der negativ gepolten Rückelektrode 17 außerhalb der Bereiche 28 in Kontakt tritt, ist zwischen den Bereichen 28 jeweils eine Isolierschicht 32 z.B. in Form eines Isolationsklebebandes zwischen den Kontaktbändchen 22 und der Rückelektrode 17 angeordnet.

Während der Abstand A der Bereiche 26 nach Figur 5 vorzugsweise das ein- bis zehnfache, insbesondere drei- bis sechsfache der Breite der Abgriffzelle C1 entspricht, beträgt der Abstand B zwischen den Bereichen 28 nach Figur 6 vorzugsweise das 0,5- bis zweifache der Breite der Abgriffzelle Cn.

## Patentansprüche

1. Photovoltaisches Modul aus miteinander verschalteten Submodulen (11, 12, 13) mit einer transparenten Frontelektrodenschicht (15), einer Halbleiterschicht (16) und einer Rückelektrodenschicht (17), welche zur Bildung serienverschalteter streifenförmiger photovoltaischer Zellen (C) jeweils Trennlinien (18, 19, 20) aufweisen, wobei die beiden äußeren Zellen (C1, Cn) jedes Submoduls (11, 12, 13) Abgriffzellen zur Stromabnahme bilden, die äußeren Zellen zweier benachbarten Submodule (11 und 12 bzw. 12 und 13) zu einer einzigen Abgriffzelle (C1, Cn) vereinigt sind, die Trennlinien (18, 19, 20) der beiden benachbarten Submodule (11 und 12 bzw. 12 und 13) zu der gemeinsamen Abgriffzelle C1, Cn) spiegelsymmetrisch angeordnet sind und die Abgriffszellen (C1, Cn) an der Rückelektrodenschicht (17) mit Kontaktbändchen (22, 23, 24) zur Stromabnahme kontaktiert sind, **dadurch gekennzeichnet**, die Abgriffzellen (C1, Cn) durch Trennlinien (26, 30) abgetrennte Bereiche (25, 28) zur Stromabnahme unter Aufrechterhaltung der Photoaktivität außerhalb dieser Bereiche (25, 28) aufweisen, wobei bei einer Abgriffszelle (C1) mit Minuspol die Trennlinien (26) in der Frontelektrodenschicht (15) und bei einer Abgriffzelle (Cn) mit Pluspol die Trennlinien (30) in der Rückelektrodenschicht (17) oder in der Rückelektrodenschicht (17) und Halbleiterschicht (16) vorgesehen sind, wobei die Halbleiterschicht (16) innerhalb der Bereiche (28) mindestens eine Trennlinie (31) aufweist und zur Stromabnahme ein Kontaktbändchen (22) vorgesehen ist, welches außerhalb der Bereiche (28) gegenüber der Rückelektrode (17) elektrisch isoliert ist.

2. Photovoltaisches Modul nach Anspruch 1, **dadurch gekennzeichnet, dass** es aus einer geraden Anzahl von Submodulen (11, 12, 13, ...) besteht.

3. Photovoltaisches Modul nach Anspruch 1, **dadurch gekennzeichnet, dass** die Kontaktbändchen (22, 23, 24) durch Löten mit der Rückelektrodenschicht (17) in den abgetrennten Bereichen (25, 28) verbunden sind.

4. Photovoltaisches Modul nach Anspruch 3, **dadurch gekennzeichnet, dass** die Abgriffszellen (C1, Cn) zum Kontaktieren durch Löten mit einer Diffusionsbarriere für die Metalle des Lots versehen sind.

5. Verfahren zur Herstellung eines photovoltaischen Moduls nach Anspruch 1, **dadurch gekennzeichnet, dass** die Kontaktbändchen (22, 23, 24) durch Löten mit der Rückelektrodenschicht (17) in den abgetrennten Bereichen (25, 28) verbunden werden.

6. Verfahren nach Anspruch 5, **dadurch gekennzeichnet, dass** die Kontaktbändchen (22, 23, 24) vorverzinnt und mit einem Flussmittel versehen sind.

7. Verfahren nach Anspruch 5 oder 6, **dadurch gekennzeichnet, dass** das Löten durch Anwendung von in das Kontaktbändchen (22, 23, 24) induktiv eingekoppelter Hochfrequenzenergie erfolgt.
